# EUROPÄISCHE PATENTANMELDUNG

(11) **EP 1 571 242 A2**
(43) Veröffentlichungstag der Anmeldung: **07.09.2005**
(21) Anmeldenummer: 05004483.3
(22) Anmeldetag: 01.03.2005
(51) Int. Cl.: C30B 29/20, C30B 33/00

(54) **Herstellung von Substratwafern für defektarme Halbleiterbauteile, ihre Verwendung, sowie damit erhaltene Bauteile**

(30) Priorität: 03.03.2004 DE 102004010377
(71) Anmelder: Schott AG, 55122 Mainz (DE)
(72) Erfinder: Gorgoni, Claudio, 1350 Orbe (CH); Speit, Burkhardt,, 55126 Mainz (DE); Köhler, Ingo,, 55218 Ingelheim (DE); Guinchard, Jaques, 1429 Giez (CH); Blaum, Peter, 64331 Weiterstadt (DE); Beier, Wolfram, 55270 Essenheim (DE)
(74) Vertreter: Fuchs Mehler Weiss & Fritzsche

(57) **Zusammenfassung**

Es wird ein Verfahren zur Herstellung von Substratwafern für defektarme Halbleiterbauteile beschrieben. Dabei wird ein Einkristall gebildet, der auf einer [0001] Fläche eine senkrecht stehende kristallographische c-Achse aufweist, in mindestens eine dünne Scheibe zerteilt und mindestens eine zu beschichtende Scheibenoberfläche geglättet und die Scheibe bei einer Temperatur oberhalb 1770 K getempert.

## Beschreibung

Die Erfindung betrifft Substrate bzw. Wafer für die Herstellung von defektarmen bzw. störstellenfreien, elektronischen Halbleiterbauteilen, insbesondere III-V Halbleiterfunktionsschichten, ein Verfahren zu ihrer Herstellung, ihrer Verwendung sowie Halbleiterbauelemente, die solche Substrate enthalten.

Elektronische Bauteile, insbesondere solche mit III-V Nitrid Halbleitertechnik erlangen eine immer größere Bedeutung, vor allem in der Hochtemperatur- und Hochleistungselektronik, bei der Herstellung von HL-Lasern und bei der Herstellung von lichtstarken Leuchtdioden, sogenannten LED, die alle in einem technisch großen Maßstab hergestellt werden. Für die Entwicklung dieser Bauteile insbesondere mit GaN fehlt es derzeit an einem geeigneten Substrat- bzw. Wafermaterial, welches keinen Unterschied (mismatch) in den beiden Kristallgittern von Substrat und kristalliner GaN-Schicht zeigt und außerdem eine hohe Transparenz und geeignete thermische Eigenschaften, wie Formstabilität bis zu Temperaturen von > 1470 K, thermische Ausdehnung und ausreichende Wärmeleitung aufweist. Ein geeignetes Substrat ist Saphir (Al₂O₃), welches in seinen physikalischen Eigenschaften dem GaN und seinen verwandten Halbleitermaterialien, wie z.B. AlN, InGaN, AlGaN oder InN nahe kommt.

Für die großtechnische Herstellung solcher Bauteile ist es notwendig, Saphirkristalle zu einem erschwinglichen Preis bereitzustellen.

Eine für die Anwendung in elektronischen Bauteilen verwendete Technik ist das Zuchtverfahren nach Czochralski. Mittels diesem Zuchtverfahren wird ein kristallographisch geordneter Materialaufbau erreicht. Ein derartiges Verfahren ist beispielsweise in der nicht vorveröffentlichten DE-A 103 06 801.5 der gleichen Anmelderin beschrieben. Dabei wird üblicherweise der Saphirkristall entlang seiner kristallographischen c-Achse, die senkrecht auf der [0001] Fläche steht, in länglichen Kristallen mit einem Durchmesser von ca. <5 bis 15 cm gezüchtet. Auf diese Weise wird ein Produkt mit rotationssymmetrischer Spannungsverteilung erhalten, welches anschließend durch Temperprozesse oberhalb 1750 K nahezu spannungsfrei wird. Auch Züchtungsverfahren entlang einer um 60° zur c-Achse verkippten Richtung sind bekannt.

Der so erhaltene Einkristall wird dann, beispielsweise durch Zersägen, in dünne Waferscheiben zerteilt. Diese Wafer dienen als Substrat bzw. als Trägermaterial für Halbleiterschichten und werden vor ihrer Weiterverarbeitung entsprechend geglättet, insbesondere gelappt und/oder geschliffen und poliert. Durch diese Bearbeitungsschritte werden zumindest an einer Oberfläche neue mechanische Spannungen im Kristall erzeugt, die vor der Weiterverarbeitung der Wafer, beispielsweise mittels Epitaxie, wieder entfernt werden sollten. Solche im Material des dünnen Wafers, der üblicherweise eine Dicke von <0,6mm aufweist, vorliegenden intrinsischen Spannungen relaxieren teilweise beim Beschichtungsprozess zwischen 1070 K und 1370 K und führen zu größeren Verformungen. Derartige Verformungen der Wafer führen zu Einbußen der Bauteileperformance (gestörtes Wachstum) und bei der Weiterverarbeitung zum fertigen Produkt zu hohen Ausbeuteverlusten. Aus diesem Grund wird in der Herstellung derartiger elektronischer Bauteile der Wafer nach dem Läppen oder Schleifen einem Tempern bis ca. 1770 K unterzogen, um die zuvor beschriebenen Spannungen verstärkt zu relaxieren. Nach einer Endpolitur sind keine Temperungen mehr möglich, da bei hohen Temperaturen mit Deformationen der polierten Substratoberfläche zu rechnen ist bzw. Verunreinigungen in der Temperatmosphäre sich bevorzugt auf der Substratoberfläche niederschlagen und mit dieser verbinden können.

Es hat sich nun gezeigt, dass beim Auftragen von heteroepitaktischen Halbleiterschichten und Halbleiterschichtpaketen verschiedene Wachstumsdefekte entstehen, insbesondere Nanopipes, Pinholes und Hilogs. Nanopipe-Strukturen, die typischerweise aus Pinholes entstehen können, [Valcheva, E., Paskova, T., Persson, A., Monemar, B., "Nanopipes in Thick GaN Films Grown at High Growth Rate", Phys. Stat. Sol. (a) 194, No. (2002): 532-535] führen beispielsweise bei LEDs durch strahlungslose Energiekonversion zu einer starken Verringerung der Lichtausbeute.

Nanopipes weisen einen hohlen, röhrenartigen Kernbereich mit einem Durchmesser <1µm auf. Diese Röhrchen können sich durch die gesamte aufgebrachte Halbleiterschicht, die ggf. aus mehreren unterschiedlichen Teilschichten besteht, fortsetzen und die Materialeigenschaften und/oder Schichtempfindlichkeit beeinflussen. Um die Ausbildung solcher Artefakte zu reduzieren, werden die Wachstumsparameter wie z. B. die Wachstumsrate und die Epitaxietemperatur optimiert. Eine existierende Nanopipe kann nicht mehr überwachsen, d. h. nach oben geschlossen werden. Die Stelle, an der die Nanopipe an der Oberfläche ausstößt, wird als "Pit" bezeichnet.

Es wird vermutet, dass die Ursachen für solche Defekte in Fehlanpassungen zwischen dem Substratmaterial und der darauf angeordneten Halbleiterschicht liegen [Kang, J., Ogawa, T., "Materials in Nanopipes of Undoped GaN", J. Mater. Res., Vol. 14, No. 1, January (1999)]. Außerdem werden Verunreinigungen der Oberfläche und Ausgasungen des Materials bei der Epitaxie als mögliche Ursachen diskutiert. Es war bislang nicht möglich, LED Schichten ohne eine nennenswerte Anzahl von Wachstumsdefekten, insbesondere Nanopipes, zu erzeugen. Eine effektive Standardmethode zur Bestimmung von Defekten an der Oberfläche ist die Interferenzmikroskopie.

Die Erfindung hat daher zum Ziel, elektronische Bauelemente bereitzustellen, die ärmer an durch kristallographische Defekte hervorgerufenen Wachstumsfehlern, insbesondere Pinholes, Nanopipes bzw. Pits und Hilogs sind, als bisher bekannte Elemente.

Dieses Ziel wird mit den in den Ansprüchen definierten Merkmalen erreicht.

Es wurde nämlich überraschenderweise gefunden, dass Halbleiterbeschichtungen möglich sind, bei denen das aufgetragene Schichtmaterial sich ohne Ausbildung von Wachstumsfehlern an der Substratoberfläche (sogenannte Pits) zeigt, wenn die Trägersubstratscheibe bzw. der Wafer nach einem ersten insbesondere mechanischen Bearbeitungsschritt der zu beschichtenden Oberfläche ggf. auch erst nach dem Läppen bzw. Schleifen, erfindungsgemäß getempert wird.

Der erfindungsgemäße Temperschritt wird vorzugsweise vor der Endpolitur und vor einer Reinigung der Substrate durchgeführt. Erfindungsgemäß wird die Temperung oberhalb 1770 K durchgeführt. Bevorzugte Tempertemperaturen betragen mindestens 1790 K, insbesondere mindestens 1820 K, wobei 1870 K bzw. 1920 K besonders bevorzugt sind. Sollen besonders ausgezeichnete Ergebnisse erzielt werden, so haben sich in Einzelfällen Tempermindesttemperaturen von 1970 K bzw. 2020 K sogar bis 2070 K als besonders zweckmäßig erwiesen. Für viele Anwendungszwecke haben sich jedoch Temperungen auf Temperaturen von oberhalb 1770 K als ausreichend erwiesen. Die Obergrenze dieses Temperschrittes liegt bei Temperaturen, bei denen das Substrat sich nicht erweicht, d. h. unterhalb des Schmelzpunktes von 2310 K. Eine bevorzugte Obergrenze beträgt 2170 K, wobei eine Obergrenze von 2120 K und insbesondere maximal 2070 K besonders bevorzugt ist. Durch die erfindungsgemäße Vorgehensweise ist es möglich, Halbleiterprodukte zu erhalten, die nur wenige und/oder keine Wachstumsdefekte wie z. B. Nanopipes und Pinholes in Form von Pits auf der Substratoberfläche aufweisen, bzw. sogar völlig frei davon sind. Ganz besonders weisen sie bei Überprüfung via Interferenzmikroskopie (Leica Interferenzmikroskop, 160-fache (16x10) Vergrößerung, Auflösung max. 0,8 µm) eine maximale Grenze an Wachstumsdefekten an der Oberfläche von 10⁴, vorzugsweise 10³ und insbesondere maximal 10²/cm² auf. Die Bestimmung der Wachstumsdefekte wird vorzugsweise ohne chemische oder mechanische Behandlung der Halbleiter-Oberfläche, wie z. B. Ätzen, durchgeführt.

Mit dem erfindungsgemäßen Verfahren ist es auch möglich, Halbleiterprodukte zu erhalten, die bei Überprüfung via Interferenzmikroskopie weniger als 10 Wachstumsdefekte pro cm² und vorzugsweise weniger als 5 bzw. maximal 2-3 aufweisen. Durch besonders sorgfältige Vorgehensweise ist es erfindungsgemäß auch ohne weiteres möglich, Produkte zu erhalten, bei denen keine Wachstumsdefekte an der Oberfläche mit Interferenzmikroskopie nachweisbar sind.

Erfindungsgemäß bevorzugte Substrate sind insbesondere Kristalle mit einer hexagonalen Struktur, die vorzugsweise eine [0001] Fläche und eine darauf senkrecht stehende kristallographische c-Achse aufweisen. Besonders geeignet sind Al₂O₃ bzw. Saphirsubstrate. Die Bildung solcher Kristalle ist an sich bekannt. Vorzugsweise werden sie mit dem Czochralski-Verfahren gewonnen. Dabei wird ein entsprechend orientierter gekühlter Kristallkeim in eine Al₂O₃-Schmelze eingetaucht und langsam aus der Schmelze herausgezogen. Vorzugsweise wird der Kristall entlang seiner c-Achse gezogen, die senkrecht zur [0001] Fläche des Saphirkristalles steht. Der so erhaltene Kristall wird üblicherweise im Ganzen getempert, um Spannungen im Einkristall abzubauen.

Ein für das erfindungsgemäße Verfahren geeigneter Kristall wird vorzugsweise so nach dem Czochralski-Verfahren hergestellt, dass ein axialer Temperaturgradient im γ Phasengrenzbereich (ca. 1 cm im gewachsenen Kristall bis zur Schmelze) von mindestens 30 K/cm eingestellt wird, womit Wachstumsgeschwindigkeiten von mindestens 40 mm/Tag erreicht werden und der Einkristall anschließend einer Temperaturbehandlung in einem vorzugsweise möglichst geringen radialsymmetrischen Temperaturgradienten bei einem insbesondere möglichst kleinen axialen Gradienten unterzogen wird.

Die Kristallzucht wird vorzugsweise entlang der kristallographischen c-Achse durchgeführt. Hierbei hat es sich gezeigt, dass die Zucht vorzugsweise mit einer Abweichung kleiner als 5° von der c-Achse erfolgen muss. Insbesondere beträgt die Abweichung jedoch weniger als 2,5°. Generell wird jedoch versucht, den Kristall so exakt wie möglich in der kristallographischen c- Richtung zu züchten.

Die Phasengrenzform zwischen Kristall und flüssiger Schmelze wird durch die Ziehgeschwindigkeit, den im ersten Zentimeter des Kristalls, von der Phasengrenze ab gerechnet, auftretenden Temperaturgradienten und letztlich durch die Drehgeschwindigkeit beeinflusst. Dabei wird die Form der Phasengrenze vorzugsweise so eingestellt, dass eine bezogen auf die Schmelze konvexe Grenzflächenwölbung entsteht. Dabei weist die Grenzflächenwölbung üblicherweise einen Radius von mindestens 0,05 m auf wobei ein Radius von insbesondere mindestens 0,2m bevorzugt ist.

Es hat sich gezeigt, dass mit den obigen Verfahrensmerkmalen hexagonale Einkristalle besonders schnell gezogen werden können, so dass Ziehgeschwindigkeiten von mindestens 30 mm/Tag insbesondere mindestens 40 mm/Tag ermöglicht werden. In vielen Fällen hat sich eine maximale Ziehgeschwindigkeit von 200 mm/Tag als geeignet erwiesen. Üblicherweise beträgt sie jedoch maximal 150 mm/Tag, insbesondere maximal 130 mm/Tag wobei maximal 120 mm/Tag besonders bevorzugt ist.

Die Temperaturbehandlung bzw. Temperung kann nach dem Zuchtprozess in einem Nachheizbereich in der Anlage oberhalb des Züchtungstiegels durchgeführt werden. In diesem Nachheizbereich lässt sich der Einkristall einfach einbringen. Es hat sich als vorteilhaft erwiesen, wenn der Einkristall bei der Temperaturbehandlung für einen Zeitraum von mindestens 1 Stunde vorzugsweise von mindestens zwei Stunden isotherm und/oder bei einer Behandlungstemperatur von mindestens 1750 K behandelt wird.

Vorzugsweise sollte bei der Züchtung des Kristalls ein axialer Temperaturgradient in Bezug auf die c-Achse eingestellt werden, der an dem Kristall im Bereich der Phasengrenzfläche, d. h. innerhalb des ersten Zentimeters zwischen Phasengrenze und bereits fertigem Einkristall, mindestens 30 K/cm beträgt. Bevorzugte Werte sind mindestens 35 K/cm und insbesondere mindestens 40 K/cm wobei speziell 50 K/cm ganz bevorzugt ist. Ein bevorzugter maximaler Gradient beträgt 200 K/cm insbesondere 150 K/cm.

Mittels dieser Temperaturgradienten lassen sich zwar noch keine völlig spannungsarmen Einkristalle erzeugen, der Spannungszustand ist aber homogen radialsymmetrisch und kann erfindungsgemäß durch die nachfolgenden Temperprozesse in einem Temperaturbereich 200 - 500 K niedriger als der Wachstumsprozess bei ca. 2320 K in einem kleinen axialen und/oder radialen Temperaturgradienten in bezug auf die c-Achse nahezu isotrop entspannt werden.

Bei dieser Vorgehensweise sollte auch darauf geachtet werden, dass mindestens bei der Temperaturbehandlung der Kristalle in einer Zuchtanlage oder in einem nachgeschalteten Prozess ein konstanter rotationssymmetrischer und/oder axialer Temperaturgradient über die gesamte Länge des Einkristalls eingestellt wird. Dieser konstante Temperaturgradient verringert anisotrope Spannungszustände in dem Einkristall.

Bei einer bevorzugten speziellen Ausführungsform kann bei der Temperaturbehandlung bzw. beim Tempern die Temperatur linear und/oder stufenweise verändert werden. Bei der stufenweisen Veränderung der Temperatur können beispielsweise bei den Phasenübergängen der metastabilen Zustände γ und η zur thermodynamisch stabilen α-Form des Saphir Pausen eingelegt werden, z.B. bei 1400 ± 25 K und/oder 1000 ± 25 K. Die Pausen weisen vorzugsweise eine Dauer von mindestens 1 Stunde insbesondere 2 Stunden auf.

Eine weitere Ausführungsform des Verfahrens zeichnet sich dadurch aus, dass eine zweistufige Temperaturbehandlung durchgeführt wird und zwar mit einer ersten Behandlungsstufe, bei der der Einkristall mit einer ersten Abkühlrate von einer ersten Behandlungstemperatur abgekühlt wird, und mit einer zweiten Behandlungsstufe, bei der der Einkristall oder ein aus dem Einkristall hergestelltes Erzeugnis mit einer kleineren zweiten Abkühlrate von einer zweiten Behandlungstemperatur aus abgekühlt wird. Das erste und schnellere, aber gesteuerte Abkühlen gefolgt von einer zweiten Behandlungsstufe, bei der langsamer abgekühlt wird, hat sich als sehr wirkungsvoll erwiesen.

Der Einkristall kann bei der ersten Behandlungsstufe isotherm in dem Nachheizbereich abgekühlt werden. Dies lässt sich nach dem Herstellen des Einkristalls einfach bewerkstelligen.

Bei einer vorteilhaften Ausgestaltung wird der Einkristall nach der Zucht im Zuchtofen bei der ersten Behandlungsstufe mit einer Abkühlrate von vorzugsweise maximal 50 K pro Stunde, insbesondere weniger als 20 K pro Stunde abgekühlt. Mit diesem verhältnismäßig schnellen aber gesteuerten Abkühlen, lassen sich bereits relativ spannungsarme Einkristalle herstellen deren Spannungen sich in der nachfolgenden zweiten Behandlungsstufe weiter reduzieren lassen.

Die erste Behandlungstemperatur oder auch in einem einstufigen Verfahren einzige Behandlungstemperatur beträgt vorzugsweise 2100 K. Insbesondere beträgt die Abweichung davon maximal ± 50 K. Bei dieser Temperatur relaxieren die Spannungszustände besonders gut.

Bei der zweiten Behandlungsstufe sollte der Einkristall mit einer Abkühlrate von weniger als 15 K pro Stunde abgekühlt werden. Dieses langsamere Abkühlen trägt einmal dem größeren Volumen eines kompletten Kristalls gegenüber einem Wafer einer Dicke von < 1 mm Rechnung und unterstützt das Ausbilden eines weitgehend spannungsfreien Einkristalls ohne Verformungseffekte.

Nach Herstellung und Abkühlung wird der so erhaltene Einkristall in dünne Scheiben zu Rohlingen zerteilt und zwar vorzugsweise entlang der [0001] Ebene des Einkristalles. Die Dicke dieser Scheiben beträgt üblicherweise weniger als 2 mm, wobei maximal 1,5 mm, insbesondere 1 mm bevorzugt ist. In vielen Fällen sind Substrat- bzw. Waferrohlinge mit einer Dicke von maximal 0,8 mm, insbesondere maximal 0,7 mm bzw. 0,6 mm besonders bevorzugt, wobei sich 0,5 mm in vielen Fällen als ausreichend erwiesen hat. Die minimale Dicke dieser Wafer beträgt üblicherweise mindestens 0,1 mm, wobei mindestens 0,2 mm, und speziell mindestens 0,3 mm besonders zweckmäßig ist. In vielen Fällen haben sich Wafer von mindestens 0,4 mm als besonders geeignet erwiesen. Die so erhaltenen dünnen Scheiben bzw. Waferrohlinge werden nach dem Zerteilen, was üblicherweise durch Zersägen geschieht, bezüglich ihrer Geometrie und Kristallorientierung untersucht und ggf. fehlorientierte Rohlinge aussortiert.

Danach werden die Scheiben-Rohlinge dann mittels Schleifen bzw. Läppen und Polieren vorzugsweise mechanisch weiterbearbeitet; dabei wird unter Läppen eine Oberflächenglättung verstanden, bei der die Oberfläche mechanisch abrasiv mit einem freien, losen Korn einer Größe von > 5µm behandelt wird. Zum Einsatz kommt dabei insbesonders z.B. die Korngröße D91, die durch Siebung mit einem Sieb der Maschenweite von 91 µm eine Kornverteilung von Körnern unter 91 µm Durchmesser garantiert, d. h. das Körner mit einem Durchmesser größer als 91 µm ausgeschlossen sind. Beim Polieren wird die Oberfläche mechanisch mit ebenfalls losen, freien Schleifkörpern bzw. Körnern einer Größe von < 5-0,1 µm behandelt. Dabei sind vorzugsweise einzelne Körner mit einem Durchmesser oberhalb 5µm ausgeschlossen, bzw. sind in den Poliermitteln nicht vorhanden. Bei diesem Verfahrensschritt kommen vorzugsweise z.B. Diamantkornverteilungen kleiner 5µm zum Tragen, die eine maximale Größe von 5µm aufweisen und durch Sedimentation, Siebung oder andere geeignete Fraktionierverfahren gewonnen werden.

Es ist bislang davon ausgegangen worden, dass nach dem mechanischen Läppen kein Tempern bei hohen Temperaturen oberhalb von 1770 K möglich ist, da bei diesen Temperaturen ein starkes durch intrinsische Spannungen hervorgerufenes Verwerfen der Oberflächen bzw. der Wafer zu erwarten ist. Dabei ist es möglich, das erfindungsgemäße Tempern der Waferscheibe entweder nach dem Schleifen/Läppen und vor dem mechanischen Polieren oder auch erst nach Schleifen/Läppen und nach mechanischen Polierprozessen, jedoch vor den meistens angewandten chemischen-mechanischen Polierprozess (CMP-Prozess) durchzuführen, bei dem mit losen Silikatkolloiden mit einem Korndurchmesser < 0,1 µm behandelt wird. Derartige Kolloide werden gezielt auf eine gewünschte Teilchengröße hergestellt und sind handelsüblich erwerbbar. Dabei erfolgt die Bestimmung des Korndurchmessers üblicherweise mittels Streulichtmessungen nach an sich bekannten Verfahren.

Das erfindungsgemäße Tempern wird vorzugsweise so durchgeführt, dass dabei die (0001) Fläche, welche auch die Oberfläche der Rohlinge darstellt, senkrecht steht. Der Ofen selbst ist vorzugsweise ein mit einer Gasmischung beschickbarer Ofen, in dessen Heizraum ggf. auch ein Vakuum angelegt werden kann. Das erfindungsgemäße Tempern ist zwar prinzipiell auch mit normaler Luft und bei Atmosphärendruck durchführbar, vorzugsweise erfolgt es jedoch mit einem reduzierten Sauerstoffpartialdruck. Dies lässt sich sowohl mittels einer Schutzgasatmosphäre, z. B. aus Stickstoff oder Argon oder auch durch Anlegen eines Vakuums erzielen. Besonders bevorzugt ist es, das Tempern mit einem reduzierten Sauerstoffpartialdruck von höchstens 10⁻¹⁰ mbar durchzuführen, wobei Sauerstoffpartialdrücke von 10⁻²-10⁻⁶ mbar, insbesonders 10⁻² - 10⁻³ mbar besonders zweckmäßig sind.

Das Tempern selbst wird erfindungsgemäß so lange durchgeführt, bis sämtliche Stör- und Defektstellen entfernt sind. Die hierzu benötigte Zeit lässt sich vom Fachmann ohne weiteres mittels einfacher Versuche feststellen und hängt auch von der Höhe der Temperatur ab. Als übliche Temperzeiten haben sich hierfür mindestens 10 Minuten als zweckmäßig erwiesen. Bevorzugte Temperzeiten betragen mindestens 30 Minuten, wobei eine Mindesttemperzeit von 1 Stunde bzw. 2 Stunden bevorzugt sind. Besonders bevorzugt sind Mindesttemperzeiten von 3 Stunden, wobei sich in vielen Fällen eine Temperzeit von 4 Stunden als besonders geeignet gezeigt hat. Temperzeiten > 4h zeigen keinen signifikanten, d. h. messbaren zusätzlichen Einfluss auf die Materialperformance. Es ist bevorzugt, das Tempern entsprechend Cleanroom Class 100.000 (ISO 14644-1/2 bzw. FS 209E) in einer staubarmen Umgebung durchzuführen, wobei eine staubfreie Temperung besonders bevorzugt ist. In einer zweckmäßigen Ausführungsform wird das Tempern in staubdichten Boxen durchgeführt, vorzugsweise in Boxen aus Edelmetall.

Wenn sich auch gezeigt hat, dass die Aufheizgeschwindigkeit beim Tempern relativ unkritisch ist, so haben sich jedoch Aufheizgeschwindigkeiten von maximal 500 K/h bzw. 400 K/h als zweckmäßig erwiesen. Bevorzugte Aufheizgeschwindigkeiten betragen maximal 300 K/h insbesondere maximal 250 K/h, wobei sich eine Aufheizgeschwindigkeit von ca. 200 K/h als besonders zweckmäßig gezeigt hat. Mit dieser Aufheizgeschwindigkeit wird der Ofen auf die gewünschte Tempertemperatur gebracht und dann entsprechend lange getempert. Nach Beendigung des Temperns wird mit einer Abkühlrate von maximal 400 K/h, vorzugsweise maximal 300 K/h auf eine Temperatur zwischen 1370 K und 1070 K abgekühlt. Besonders zweckmäßige Abkühlraten bis zu dieser ersten Temperatur sind maximal 200 K/h, wobei maximal 150 K/h sich als besonders zweckmäßig erwiesen haben. Eine übliche Abkühlrate beträgt bis auf eine Temperatur von vorzugsweise 1070 K bis 670 K ca. 100 K/h. Eine typische Erstabkühltemperatur mit einer gezielten Abkühlrate beträgt ca. 1070 K. Anschließend erfolgt vorzugsweise eine Kühlung im abgeschalteten Ofen, wobei man den abgeschalteten Ofen auf Raumtemperatur abkühlen läßt. Eine derartige Kühlung beträgt üblicherweise 12 bis 48 Stunden, wobei 16 bis 32 Stunden bevorzugt sind. Eine übliche Abkühlzeit bzw. -rate beträgt 20 bis 28 Stunden, wobei ca. 24 Stunden zweckmäßig sind.

Erfolgt nach dem erfindungsgemäßen Temperschritt ggf. ein mehrstufiger Polierprozess, darf dabei jedoch in Summe die durch das Tempern von Defektstellen befreite Oberflächenschicht nicht vollständig abgetragen werden. Es hat sich gezeigt, dass hierbei ein Abtrag von maximal 15 µm, vorzugsweise maximal 10 µm geeignet ist. Besonders bevorzugt sollte der Abtrag nicht mehr als 8 µm und üblicherweise nicht mehr als 5 µm betragen.

Die so erhaltenen oberflächengeglätteten Schichten werden dann auf übliche Art und Weise gewaschen bzw. gereinigt, was vorzugsweise unter Reinraumbedingungen erfolgt, wie sie beispielsweise für die Cleanroom class 100 festgelegt sind (ISO 14644-1/2 oder FS 209E, siehe auch
www.particle.com/whitepapers_met/cleanroom%20standards. htm).

Danach sind die Substrat-/Trägermaterialien bzw. Wafer fertig für eine Beschichtung mit halbleitenden Materialien wie beispielsweise GaN, AlN, InGaN, AlGaN oder InN. Die Beschichtung der Wafer bzw. Trägersubstrate erfolgt mittels handelsüblicher Verfahren, wie beispielsweise einem MOCVD Beschichter, wie er z.B. von "AIXTRON AG", Aachen, Deutschland oder "Veeco Instruments Inc.", Somerset, NJ, USA erhältlich ist.

Die Erfindung betrifft auch die Verwendung der erfindungsgemäß erhaltenen Trägersubstrate bzw. Wafer zur Herstellung elektronischer Bauelemente sowie die Bauelemente selbst. Erfindungsgemäß bevorzugte Bauelemente sind elektronische Bauteile in der Hochtemperatur- und Hochleistungstechnik (HEMT, HBT & SAW) zur Herstellung von HL-Lasern und insbesondere zur Herstellung von lichtstarken Leuchtdioden (LED).

Die Erfindung soll anhand der folgenden Beispiele kurz näher erläutert werden.

Es wurde, wie in der DE-A-103 06 801.5 beschrieben, ein zylindrischer Saphireinkristall nach dem Czochralski-Verfahren entlang seiner c-Achse gezogen, wobei hochreine Rohstoffe mit einem Gesamtverunreinigungsgrad von ambivalenten Metalloxiden wie Fe-, Ti- und Cr-oxid von <50 ppm eingesetzt werden. Daraus wurden Testwafer von 5 cm Durchmesser mit einer Dicke von 0,35 mm bzw. 0,48 mm herausgesägt.

Bei den später folgenden Verfahrensschritten Polieren und Läppen erfolgt ein zusätzlicher Abtrag der Dicke von ca. 0,05 mm ± 0,02 mm. Nach dem Läppen wurden die so erhaltenen Testwafer in einem mit Superkantalheizelementen bestückten Standardtemperofen mit Mullitauskleidung der Firma NABER, Lilienthal, Deutschland getempert. Der Sauerstoffpartialdruck der Ofenatmosphäre betrug 10⁻² mbar.

Dabei wurden die Wafer in einer dicht schließenden, aus Iridium oder Pt-Legierung bestehenden Box, und zwar auf dem Außendurchmesser, in mit aus Iridium- oder Platindrähten gespannten Führungsrahmen senkrecht stehend in den Ofen eingebracht und mit einer Aufheizgeschwindigkeit von 200 K/h auf die Zieltemperatur zwischen 1770 K und 2070 K erwärmt und bei dieser Temperatur vier Stunden lang gehalten. Danach wurde mit einer Abkühlrate von 100 K/h auf 1070 K abgekühlt, worauf im abgeschalteten Ofen in einem Zeitraum von ca. 24 Stunden die Abkühlung auf Raumtemperatur erfolgte. Im vorliegenden Beispiel wurden die Testwafer nach dem ersten mechanischen Bearbeitungsprozess, d. h. dem Läppen auf Waferdicken von ca. 0,34 mm bis 0,36 mm getempert und anschließend wie üblich auf eine Enddicke von 0,33 mm poliert, gewaschen und schließlich unter Reinraumbedingungen (Cleanroom class 100) nachgereinigt und entsprechend der Forderung "epi ready" (=epitaxy ready), d. h. ohne weitere Nachverarbeitungsschritte für den Epitaxieprozess beim Anwender direkt geeignet, verpackt.

Dieses Verfahren wurde bei Tempertemperaturen von 1770 K bis 2070 K in 50 K-Schritten wiederholt und die jeweilig erhaltenen Wafer wurden anschließend mit einem handelsüblichen MOCVD Beschichter der Firma "AIXTRON AG", Aachen weiterverarbeitet und zwar so, dass auf dem Saphir eine 25 nm dicke GaN-Nukleationsschicht, darauf eine 2000 nm dicke GaN-Schicht und dann eine 1500 nm dicke GaN:Si-Schicht als n-Schicht aufgebracht wurde. Darüber folgte eine dünne InₓGaᵢ₋ₓN SQW-Schicht und darauf eine 60 nm dicke Al_{0,1}Ga_{0,9}N:Mg-Schicht, welche von einer 200 nm dicken GaN:Mg-Schicht abgedeckt wurde und die als p-Seite einer Diode dienten. Die Schichten der so erhaltenen Dioden wurden anschließend mit optischer Mikroskopie bei 200facher Vergrößerung untersucht und die Anzahl der Pits pro cm² bestimmt. Die Ergebnisse sind in der folgenden Tabelle 1 dargestellt:

**Tabelle 1**

| Temperniveau nach Läppen/Schleifen (K) | Anzahl Pits/cm² |
|---|---|
| 1770 | 4x10exp5 |
| 1820 | 8x10exp4 |
| 1870 | 9x10exp2 |
| 1920 | 2x10exp2 |
| 1970 | vereinzelt |
| 2020 | Sehr vereinzelt |
| 2070 | Nicht nachweisbar |

## Patentansprüche

1. Verfahren zur Herstellung von Substratwafern für defektarme Halbleiterbauteile durch Bilden eines Einkristalles, der auf einer [0001] Fläche eine senkrecht stehende kristallographische c-Achse aufweist, sowie Zerteilen des Einkristalles in mindestens eine dünne Scheibe und Glätten mindestens einer zu beschichtenden Scheibenoberfläche **dadurch gekennzeichnet, dass** die Scheibe bei einer Temperatur oberhalb 1770 K getempert wird.

2. Verfahren nach Anspruch 1, **dadurch gekennzeichnet, dass** das Tempern bei vermindertem O₂-Partialdruck durchgeführt wird.

3. Verfahren nach den vorliegenden Ansprüchen, **dadurch gekennzeichnet, dass** die Temperung in staubarmer Umgebung erfolgt.

4. Verfahren nach einem der vorhergehenden Ansprüche,
**dadurch gekennzeichnet, dass** mindestens 10 Minuten oberhalb 1770 K getempert wird.

5. Verfahren nach einem der vorhergehenden Ansprüche,
**dadurch gekennzeichnet, dass** der Kristall ein Al₂O₃-Einkristall mit hexagonaler Struktur ist.

6. Verfahren nach einem der vorhergehenden Ansprüche,
**dadurch gekennzeichnet, dass** der Kristall in einer Ebene zerteilt wird, der senkrecht zu einer kristallographischen Achse verläuft.

7. Substratwafer für defektfreie Halbleiterbauelemente, erhältlich nach dem Verfahren nach einem der Ansprüche 1 bis 6.

8. Verwendung des Wafers nach Anspruch 6 zur Herstellung von elektronischen Bauteilen in der Hochtemperatur- und Hochenergietechnik, in Lasern und in lichtstarken Leuchtdioden.

9. Elektronisches Halbleiterbauteil, umfassend ein Substrat sowie eine oder mehrere übereinanderliegende darauf angeordnete defektarme Schichten aus halbleitenden Materialien erhältlich durch Herstellen eines Einkristalles und ggf. Tempern des Einkristalles, Zerteilen des Einkristalles zu Scheiben, Schleifen und/oder Läppen und Polieren sowie Tempern der so erhaltenen Scheiben, Endpolieren und Reinigen mindestens einer Scheibenoberfläche, sowie anschließende Beschichtung der Oberfläche mit halbleitenden Materialien, **dadurch gekennzeichnet, dass** das defektarme Halbleiterelement durch Tempern der Substratscheibe vor deren Endpolitur und Beschichtung auf eine Temperatur von oberhalb 1770 K erhältlich ist.
